# DEMANDE DE BREVET EUROPEEN

(11) **EP 1 816 689 A1**
(43) Date de publication de la demande: **08.08.2007**
(21) Numéro de dépôt: 07101675.2
(22) Date de dépôt: 02.02.2007
(51) Int. Cl.: H01L 49/00, H01L 29/76

(54) **Structure de transistor ou de triode à effet tunnel et à nanocanal isolant**

(30) Priorité: 07.02.2006 FR 0650437
(71) Demandeur: ST Microelectronics Crolles 2 SAS, 38920 Crolles (FR)
(72) Inventeur: Skotnicki,, Thomas, 38920, Crolles-Montfort (FR); Monfray, Stéphane, 38000, Grenoble (FR)
(74) Mandataire: Poulin, Gérard

(57) **Abrégé**

L'invention concerne un dispositif microélectronique doté d'au moins un transistor ou triode, à modulation de courant tunnel de type Fowler-Nordheim reposant sur un substrat (101-100), la triode ou le transistor comprenant:
- au moins un premier bloc (110) destiné à jouer le rôle de cathode et au moins un deuxième bloc (112) destiné à jouer le rôle d'anode, le premier bloc et le deuxième bloc reposant sur le substrat et étant séparés par une zone isolante (115) de canal reposant sur le substrat,
- au moins une zone (118) de diélectrique de grille, reposant au moins sur ladite zone isolante (115) de canal, et au moins une grille (120) reposant sur ladite zone (118) de diélectrique de grille. L'invention concerne également un procédé de réalisation d'un tel dispositif.

## Description

### DOMAINE TECHNIQUE

L'invention s'applique au domaine de la microélectronique et en particulier aux dispositifs microélectroniques à modulation de courant tunnel Fowler-Nordheim. L'invention concerne en particulier un dispositif microélectronique doté d'au moins un transistor ou d'au moins une triode amélioré(e), comprenant : des électrodes, un canal isolant de l'ordre du nanomètre ou de la dizaine de nanomètres séparant lesdites électrodes, et au moins une grille de contrôle du courant de Fowler-Nordheim formée sur le canal isolant. L'invention concerne également un procédé de réalisation d'un tel dispositif.

### ART ANTÉRIEUR

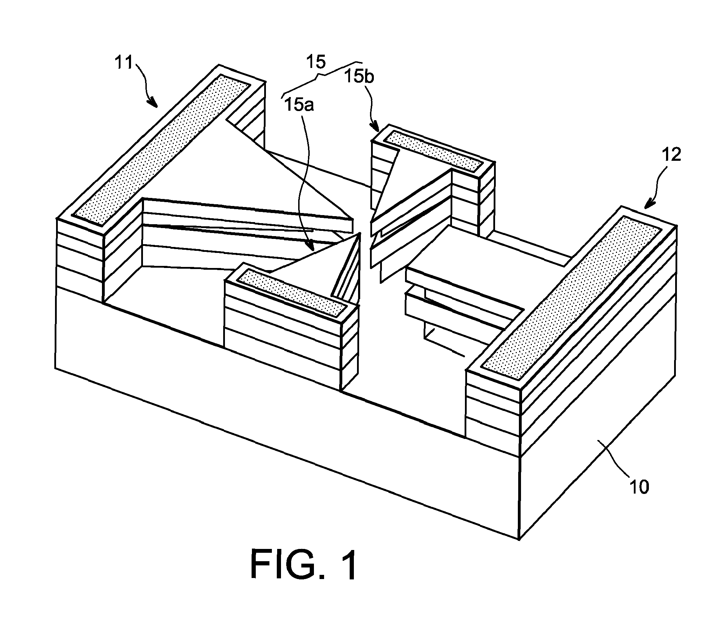

Un dispositif microélectronique à modulation de courant tunnel Fowler-Nordheim, suivant l'art antérieur, est présenté dans le document : « Fabrication of Lateral Field Emission Triode with a High Current Density and High Transconductance Using the Local Oxidation of the polysilicon Layer », Park et al. , IEEE Transactions on electron devices, vol. 46, n°6, juin 1999*.* Un tel dispositif est illustré sur la figure 1 et comprend : une cathode 11 et une anode 12 en regard l'une de l'autre, séparées par un espace vide de canal, et reposant sur un substrat 10, par exemple de type semi-conducteur sur isolant. Le canal a une longueur qui peut être de l'ordre d'une centaine de nanomètres. La cathode 11 est dotée d'une forme pointue, favorisant l'émission d'électrons. Le dispositif comprend également une grille 15 pour contrôler le flux d'électrons entre la cathode 11 et l'anode 12. La grille 15 est située entre la cathode 11 et l'anode 12 et formée dans le même plan que la ces dernières. La grille 15 est également formée de deux parties 15a, 15b, distinctes dotées d'une forme pointue et situées en regard l'une de l'autre.

La modulation du courant de Fowler-Nordheim au sein d'un tel dispositif requiert l'application de tensions élevées. Par ailleurs, notamment à cause de la forme des électrodes, il semble également difficile de pouvoir réaliser un canal inférieur à 100 nanomètres pour un tel dispositif.

Il se pose le problème de trouver une nouvelle structure à modulation de courant de tunnel Fowler-Nordheim, améliorée en termes de consommation et d'encombrement, ainsi qu'un procédé de réalisation d'une telle structure.

### EXPOSÉ DE L'INVENTION

La présente invention a pour but de proposer un dispositif microélectronique amélioré de modulation de courant tunnel de type Fowler-Nordheim, et en particulier une structure de transistor ou de triode amélioré(e), comprenant :
- dans un même premier plan, au moins une cathode, au moins une anode, et au moins un canal isolant séparant la cathode et l'anode, le canal ayant par exemple une longueur ou dimension critique de l'ordre du nanomètre ou de la dizaine de nanomètres,
- dans un deuxième plan différent du premier plan, au moins une grille de contrôle d'un courant de Fowler-Nordheim entre la cathode et l'anode.

La présente invention concerne en particulier un dispositif microélectronique doté d'au moins un transistor ou triode, à modulation de courant tunnel Fowler-Nordheim, et reposant sur un substrat, le transistor ou la triode comprenant :
- au moins un premier bloc destiné à jouer le rôle d'anode dudit transistor ou de ladite triode, et au moins un deuxième bloc destiné à jouer le rôle de cathode dudit transistor ou de ladite triode, le premier bloc et le deuxième bloc reposant sur ledit substrat et étant séparés par une zone de canal isolante reposant également sur ledit substrat,
- au moins une zone de diélectrique de grille, reposant sur ladite zone isolante de canal, et au moins une grille reposant sur ladite zone de diélectrique de grille.

La zone isolante de canal peut avoir une dimension critique comprise entre 1 et 20 nanomètres, ou entre 1 et 10 nanomètres, ou inférieure à 5 nanomètres.

On entendra tout au long de la présente description par « dimension critique », la dimension minimale d'un motif géométrique réalisé dans une couche mince ou à partir d'une couche mince, hormis la ou les dimensions définies par l'épaisseur de cette couche mince.

Le premier bloc d'anode et le deuxième bloc de cathode peuvent comprendre au moins une première couche à base d'au moins un premier matériau, conducteur ou semi-conducteur, choisi de sorte que la barrière énergétique ou de potentiel entre le premier matériau et ladite zone isolante, est faible.

Ledit premier matériau peut être métallique. Le premier bloc et le deuxième bloc peuvent comprendre respectivement : au moins une première zone métallique et au moins une deuxième zone métallique, la première zone métallique et la deuxième zone métallique étant séparées par la zone de canal isolante.

Selon un mise en oeuvre particulière, le premier bloc et/ou le deuxième bloc peuvent comprendre au moins un empilement de deux couches de matériaux différents.

Selon cette mise en oeuvre particulière, le premier bloc d'anode et le deuxième bloc de cathode peuvent comprendre respectivement, au moins une première couche à base du premier matériau, et au moins une autre couche sur laquelle repose la première couche et à base d'au moins un deuxième matériau, conducteur ou semi-conducteur, le deuxième matériau ayant été choisi de sorte que la barrière énergétique ou de potentiel entre ledit deuxième matériau et ladite zone isolante, est élevée ou plus élevée que la barrière énergétique ou de potentiel entre ledit premier matériau et ladite zone isolante.

Ledit deuxième matériau peut être semi-conducteur. Le premier bloc et le deuxième bloc peuvent comprendre, respectivement : au moins une troisième zone, semi-conductrice, sur laquelle repose la première zone métallique, et au moins une quatrième zone, semi-conductrice sur laquelle repose ladite deuxième zone métallique, la troisième zone semi-conductrice et la quatrième zone semi-conductrice étant séparées par la zone isolante de canal.

Le canal isolant peut être tel que la distance minimale dc1 séparant lesdites première et deuxième zones, métalliques, est inférieure à la distance minimale dc2 séparant lesdites troisième et quatrième zones, semi-conductrices.

Selon une possibilité de mise en oeuvre du dispositif, ladite troisième zone et ladite quatrième zone peuvent avoir une épaisseur e₂, tandis que ladite première zone et ladite deuxième zone ont une épaisseur e₁, telle que e₁ < e₂.

Selon une possibilité de mise en oeuvre, la zone de diélectrique de grille peut avoir une épaisseur e₃ donnée, supérieure ou égale à la dimension critique de la zone de canal isolante.

Selon une variante de mise en oeuvre, la zone isolante de canal et la zone de diélectrique de grille, peuvent être à base de matériaux diélectriques différents.

La zone isolante de canal peut être à base d'un matériau diélectrique de constante diélectrique élevée communément appelé « high-k », ou de constante diélectrique k₁, telle que k₁ > 4,3.

La zone de diélectrique de grille peut être également à base d'un matériau diélectrique de constante diélectrique élevée communément appelé « high-k », ou de constante diélectrique k₃, telle que k₃ > 4,3.

La zone de diélectrique de grille peut être à base d'un matériau diélectrique de constante diélectrique k₃, supérieure à la constante diélectrique k₁ de la zone isolante de canal.

L'invention concerne également un procédé de réalisation d'un tel dispositif.

L'invention concerne en particulier un procédé de réalisation d'un dispositif microélectronique doté d'au moins un transistor ou triode à effet tunnel, comportant les étapes consistant à :
a) fournir un substrat recouvert d'une ou plusieurs couches minces,
b) réaliser dans lesdites couches minces au moins une tranchée séparant au moins un premier bloc destiné à jouer le rôle de cathode dudit transistor ou de ladite triode, et au moins un deuxième bloc destiné à jouer le rôle d'anode dudit transistor ou de ladite triode,
c) remplir la tranchée à base d'au moins un matériau diélectrique, de manière à former une zone isolante de canal entre ledit premier bloc et ledit deuxième bloc,
d) former au moins une zone de diélectrique de grille reposant sur ladite zone isolante de canal et au moins une grille sur ladite zone de diélectrique de grille.

La zone isolante de canal peut avoir une dimension critique comprise entre 1 et 20 nanomètres, ou entre 1 et 10 nanomètres, ou inférieure à 5 nanomètres.

Selon une possibilité de mise en oeuvre, ladite zone de diélectrique de grille peut avoir une épaisseur e₃ donnée, supérieure à la dimension critique de ladite zone isolante de canal.

Selon une première variante de mise en oeuvre, la formation de la zone de diélectrique de grille peut comprendre : le dépôt d'une couche de diélectrique de grille sur le premier bloc, la zone isolante de canal et le deuxième bloc, ladite couche de diélectrique de grille et ladite zone isolante de canal étant à base de matériaux diélectriques différents.

Selon une deuxième variante de mise en oeuvre du procédé dans laquelle à l'étape c), le remplissage est réalisé de manière à déborder de l'embouchure de la tranchée et à former une couche à base dudit matériau diélectrique reposant sur le premier bloc, le deuxième bloc et la tranchée remplie, la formation de la zone de diélectrique de grille à l'étape d) peut comprendre : la gravure de ladite couche à base dudit matériau diélectrique.

Selon une mise en oeuvre possible, la zone isolante de canal peut être formée à l'étape c) à base d'un matériau diélectrique de constante diélectrique élevée (« high-k » selon la terminologie anglo-saxonne) ou de constante diélectrique k₁ > 4,3.

Lesdites couches minces peuvent comprendre au moins une première couche à base d'au moins un premier matériau, conducteur ou semi-conducteur, choisi de sorte que la barrière énergétique ou de potentiel entre ledit premier matériau et ladite zone isolante, est faible.

Selon une possibilité, ladite première couche peut être métallique.

Lesdites couches minces peuvent comprendre un empilement d'au moins une première couche et d'au moins une deuxième couche reposant sur la première couche et à base d'au moins matériau différent de la première couche.

Selon une possibilité, ladite deuxième couche peut être semi-conductrice.

Selon une variante de mise en oeuvre du procédé, à l'étape c), la formation de la tranchée peut comprendre :
- une gravure anisotrope de manière à former un premier trou dans ladite première couche, et un deuxième trou dans ladite deuxième couche et dans le prolongement du premier trou,
- une gravure isotrope de ladite deuxième couche, sélective vis-à-vis de la première couche, de manière à élargir le deuxième trou.

Selon une possibilité de mise en oeuvre du procédé dans lequel ladite première couche et ladite deuxième couche ont respectivement, une première épaisseur e₁ et une deuxième épaisseur e₂, ladite première épaisseur e₁ peut être inférieure à ladite deuxième épaisseur e₂.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1, déjà décrite, représente un exemple de dispositif microélectronique selon l'art connu,
- les figures 2A et 2B illustrent respectivement : un exemple de dispositif microélectronique de triode ou transistor à effet tunnel de type Fowler Nordheim, et une variante améliorée de ce dispositif microélectronique,
- les figures 3A-3B, 4, 5 illustrent des caractéristiques électriques d'un exemple d'un dispositif microélectronique suivant l'invention,
- les figures 6A-6E illustrent un procédé de réalisation d'un dispositif microélectronique suivant l'invention,
- les figures 7A-7B illustrent une variante de procédé de réalisation d'un dispositif microélectronique suivant l'invention.

Des parties identiques, similaires, ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

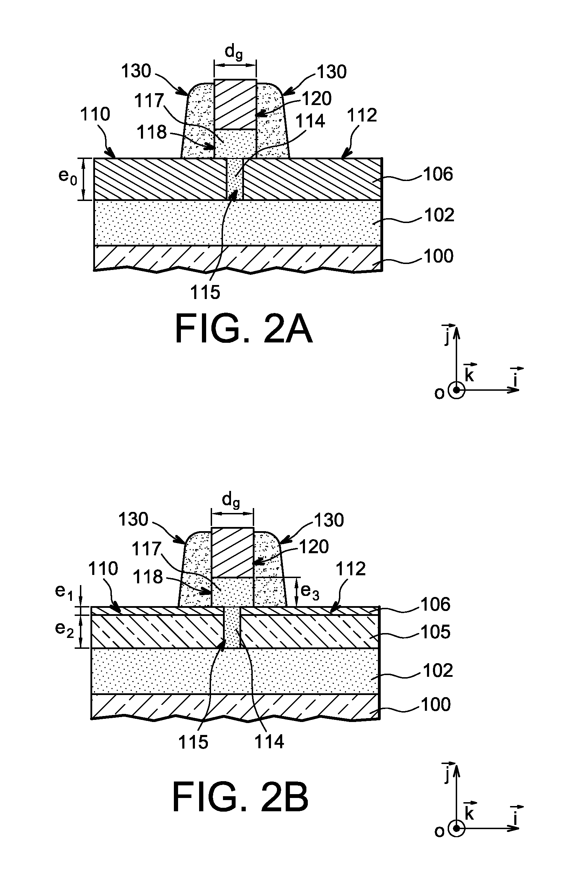

Un exemple de dispositif microélectronique doté d'au moins une triode ou d'au moins un transistor, à modulation de courant tunnel Fowler-Nordheim, va à présent être donné en liaison avec la figure 2A.

Cette triode ou ce transistor est formé sur un substrat qui peut comprendre un support 100 à base d'un matériau semi-conducteur, par exemple du silicium, recouvert d'une couche isolante 102, par exemple à base de SiO₂. Des blocs 110 et 112 distincts, reposent sur la couche isolante 102 et sont destinés à former respectivement, une anode et une cathode pour le transistor ou la triode. Les blocs 110 et 112 peuvent avoir une épaisseur e₀ (mesurée dans une direction parallèle à un vecteur *j̅* d'un repère orthogonal [O*;i̅;j̅;k*] indiqué sur les figures 2A et 2B) comprise par exemple entre 1 nanomètre et 10 nanomètres. Les blocs 110 et 112 sont séparés par une zone de canal 115 isolante, reposant sur le substrat. L'espace minimal entre les blocs 110 et 112 ou la dimension critique dc (mesurée dans une direction parallèle au vecteur *̅i̅*̅ du repère [O*;i̅;j̅;k̅*]) de la zone isolante 115 de canal peut être comprise par exemple entre 1 et 20 nanomètres, ou entre 1 et 10 nanomètres, ou être inférieure à 5 nanomètres, par exemple de l'ordre de 2 nanomètres. La zone isolante 115 de canal peut être à base d'au moins un matériau diélectrique 114 par exemple tel que du SiO₂, tel qu'un matériau de constante diélectrique élevée communément appelé « high-k » ou ayant une constante diélectrique k₁ au moins supérieure à 4,3. La zone isolante 115 de canal peut être par exemple à base d'un matériau « high-k » choisi parmi les matériaux suivants : HfO₂, ZrO₂, Y₂O₃, LaO₂. Les blocs 110, 112, d'anode et de cathode, comprennent au moins une couche à base d'au moins un premier matériau 106 conducteur ou semi-conducteur, choisi de sorte que la barrière énergétique ou de potentiel entre la zone isolante de canal 115 et la couche à base du premier matériau 106, est faible. Ledit matériau peut être un métal, par exemple du césium, notamment dans un cas où la zone de canal isolante 115 est à base de SiO₂.

Une autre zone isolante 118, à base d'un matériau diélectrique 117 de grille, par exemple du SiO₂, repose sur la zone isolante 115 de canal, et éventuellement sur les blocs 110 et 112. Selon une variante, la zone isolante 115 de canal et la zone 118 de diélectrique de grille, peuvent être formées de matériaux diélectriques 114, 117 différents. La zone 118 de diélectrique de grille peut être éventuellement à base d'un matériau diélectrique « high-k » ou ayant une constante diélectrique k₃ au moins supérieure à 4,3. La zone 118 de diélectrique de grille peut être à base d'un matériau diélectrique de constante diélectrique k₃, supérieure à la constante diélectrique k₁ de la zone isolante de canal. La zone 118 à base de diélectrique de grille a une épaisseur e₃ (mesurée dans une direction parallèle au vecteur *̅j̅*̅ du repère [O*;i̅;j̅;k̅*]), par exemple comprise entre 1 nanomètre et 5 nanomètres, et de préférence supérieure à la dimension critique dc de la zone isolante 115 de canal. La zone 118 de diélectrique de grille est surmontée d'une grille 120 formée d'un bloc à base de matériau de grille, par exemple à base d'un semi-conducteur tel que du polySi ou du polySiGe, ou/et d'un métal tel que du molybdène, du TiN, ou du TaN. La grille 120 peut avoir une dimension critique dg comprise entre 2 et 20 nanomètres. La grille 120 est située en regard de la zone isolante de canal 115 et dans un plan différent de celui des blocs 110 et 120 d'anode et de cathode. Le dispositif peut également comprendre des zones isolantes 130 communément appelées « espaceurs » (« spacers selon la terminologie anglo-saxonne) formées de part et d'autre de la grille 120.

La figure 2B illustre une variante améliorée du dispositif précédemment décrit, pour laquelle les blocs 110 et 112 sont formés d'un empilement comportant une couche à base d'au moins un premier matériau 106 reposant sur une autre couche à base d'au moins un deuxième matériau 105, différent du premier matériau 106. Par matériaux « différents » 105, 106 on entend par exemple que la barrière énergétique ou de potentiel entre la zone isolante de canal et la couche de premier matériau est différente de la barrière énergétique ou de potentiel entre la zone isolante de canal et la couche de deuxième matériau. Le deuxième matériau 105 peut être choisi de manière à ce que la barrière énergétique ou de potentiel entre la zone isolante de canal 115 et la couche de deuxième matériau 105, est élevée, tandis que le premier matériau 106 est quant à lui choisi de sorte que la barrière énergétique ou de potentiel entre la zone isolante de canal 115 et le premier matériau 106, est faible ou/et plus faible que la barrière énergétique ou de potentiel entre la zone isolante de canal 115 et le deuxième matériau 105.

Le premier matériau 106 peut être métallique. Le premier matériau 106 peut être par exemple du césium, notamment dans un cas où la zone isolante 115 est à base de SiO₂, ou peut être à base de l'un des matériaux suivants : Ta, Ti, TiW, Al, Zr, ZrSi₂, TiSi₂, notamment dans un cas où le deuxième matériau 105 est un semi-conducteur dopé N et éventuellement lorsque la zone isolante de canal 115 est à base d'un matériau « high-k ». Le premier matériau 106 peut être à base de l'un des matériaux suivants : Pd, Ir, Ru, Os, Pt, notamment dans un cas où le deuxième matériau 105 est un semi-conducteur dopé P et éventuellement lorsque la zone isolante de canal 115 est à base d'un matériau « high-k ». Le deuxième matériau 105 peut quant à lui être semi-conducteur, par exemple du Si ou du SiGe ou du Ge, éventuellement dopé N ou P. Dans les blocs 110 et 112 d'anode et de cathode, la couche de premier matériau 106 peut avoir une épaisseur e₁ comprise par exemple entre 0,5 et 5 nanomètres, tandis que la couche de deuxième matériau 105 a une épaisseur e₂ qui peut être plus élevée que l'épaisseur e₁ de la couche de premier matériau 106, et comprise par exemple entre 2 et 10 nanomètres.

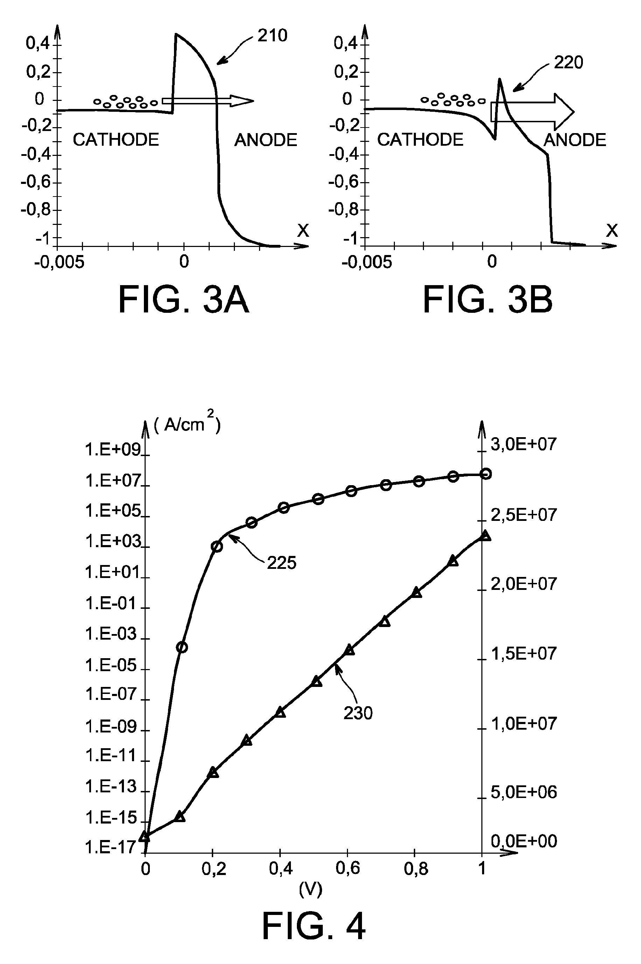

Le fonctionnement d'un tel dispositif repose sur une modulation d'un courant tunnel de type Fowler Nordheim entre la cathode et l'anode (figures 3A, 3B, 4 et 5). Ce courant est modulé en fonction de potentiels Vg, Vc, Va destinés à être appliqués respectivement sur la grille 120, sur le bloc 112 de cathode et sur le bloc 110 d'anode. La largeur de bande interdite dans la zone isolante 115 de canal peut être modulée en fonction du potentiel Vg que l'on applique sur la grille 120, comme cela est illustré sur les figures 3A et 3B.

Sur la figure 3A un premier profil 210 d'énergie de bande de conduction, pour un premier état de polarisation donné du transistor ou de la triode, par exemple tel que Vg = 0 volt et Va = 1 volt, est représenté. Pour ce premier état de polarisation, le champ électrique E1 à l'interface cathode/zone de canal isolant, peut être par exemple de l'ordre de 2*10⁶ V/cm.

La figure 3B montre quant à elle un deuxième profil 220 d'énergie de bande de conduction, pour un autre état de polarisation donné du transistor ou de la triode, par exemple tel que Vg = 1 volt et Va = 1 volt. Pour ce deuxième état de polarisation, le champ électrique E2 à l'interface cathode/zone de canal isolant, peut être par exemple de l'ordre de 2*10⁷ V/cm

Sur la figure 4 une courbe 225 représentative d'une caractéristique courant de Fowler-Nordheim/tension de grille Vg, ainsi qu'une courbe 230 représentative du champ électrique à l'interface entre le bloc de cathode 112 et la zone isolante 115 de canal en fonction de tension de grille Vg, sont données pour un exemple de dispositif microélectronique tel que décrit précédemment en liaison avec la figure 2B. La courbe 225 montre qu'au sein d'un dispositif microélectronique suivant l'invention, la variation du courant de Fowler Nordheim peut être très importante, pour une faible variation du potentiel de polarisation appliqué sur la grille 120.

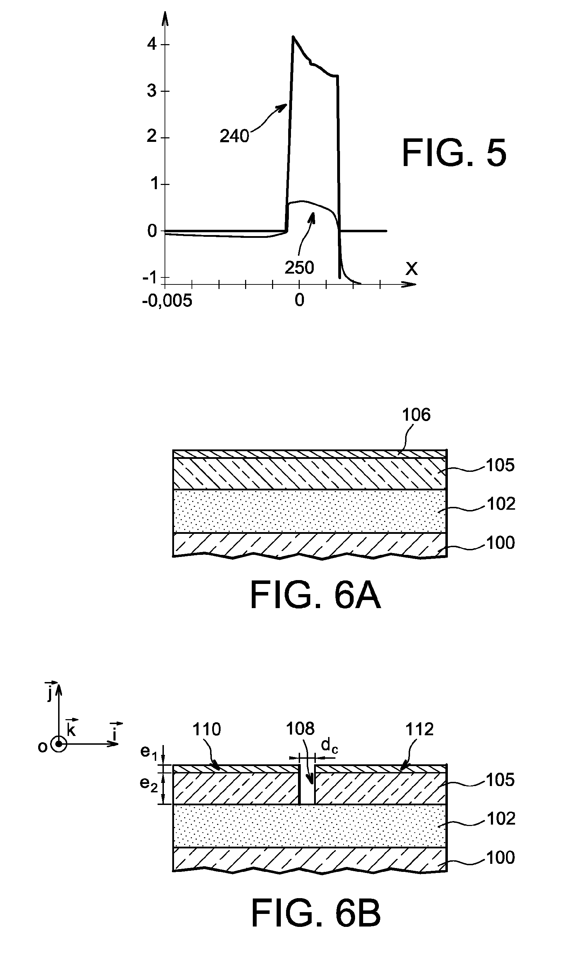

Le dispositif décrit précédemment en liaison avec la figure 2B, peut être doté de performances électriques améliorées par rapport à un dispositif dans lequel les blocs 110 et 112 d'anode et de cathode sont formés uniquement à base du premier matériau 106. Un empilement de couches de matériaux différents, permet de mettre en oeuvre plusieurs barrières de potentiel différentes suivant à quelle hauteur (définie dans une direction parallèle au vecteur *̅j̅*̅ du repère [O*;i̅;j̅;k̅*]), de la zone isolante 115 de canal on se situe. Un empilement bicouches de matériaux 105, 106, différents, permet en particulier de mettre en oeuvre une double barrière, comme cela est illustré sur la figure 5. Cette figure 5 représente, pour un dispositif microélectronique mis en oeuvre suivant l'invention et tel que décrit précédemment en liaison avec la figure 2B : un profil 240 d'énergie de bande de conduction pour une région du canal 150, située le long d'un axe parallèle au vecteur *̅i̅*̅ entre des régions du premier bloc d'anode 110 et du deuxième bloc 112 de cathode qui sont à base du deuxième matériau 105, ainsi qu'un autre profil 250 d'énergie de bande de conduction d'une autre région du canal 150, située le long d'un axe parallèle au vecteur *̅i̅*̅ entre des régions du premier bloc d'anode 110 et du deuxième bloc 112 de cathode qui sont à base du premier matériau 106. La mise en oeuvre d'un empilement de couches de matériaux différents 105, 106, permet de supprimer ou de réduire de manière importante des courants de fuites dus à des phénomènes d'abaissement de la barrière de conduction, et semblables aux phénomènes communément appelés de DIBL (DIBL pour « Drain Induced Barrier Lowering ») dans les transistors MOS.

Le dispositif microélectronique suivant l'invention n'est pas limité à une structure simple grille telle que décrite précédemment, et peut comprendre par exemple, une structure double-grille, dotée d'au moins deux motifs à base de matériau de grille, situés de part et d'autre de la zone isolante 115 de canal et dans des plans différents de celui de la cathode et de l'anode.

Un exemple de procédé de réalisation d'un dispositif microélectronique suivant l'invention, du type de celui qui vient d'être décrit, va à présent être donné en liaison avec les figures 6A-6E. Le matériau de départ de ce procédé peut être un substrat formé d'un support 100, qui peut être semi-conducteur, par exemple à base de silicium, recouvert d'une couche isolante 102, par exemple à base de SiO₂. Sur la couche isolante 102, une couche, d'épaisseur e₂ par exemple comprise entre 2 et 10 nanomètres et à base d'un matériau 105 que l'on appellera « deuxième matériau » est formée, par exemple par dépôt ou par collage. Le deuxième matériau 105 peut être semi-conducteur tel que du Si, ou par exemple du Ge, ou du SiGe. Ensuite, une autre couche d'épaisseur e₁ par exemple comprise entre 0,5 et 5 nanomètres et à base d'un matériau 106 que l'on appellera « premier matériau », par exemple un matériau métallique est réalisé sur le deuxième matériau 105. Le premier matériau 106 peut être l'un des matériaux suivants : Cs, Ta, Ti, TiW, Al, Zr, ZrSi₂, TiSi₂, notamment dans un cas, pour lequel le deuxième matériau 105 est un semi-conducteur destiné à être dopé N. Le premier matériau 106 peut être l'un des matériaux suivants : Pd, Ir, Ru, Os, Pt, notamment dans un autre cas, où le deuxième matériau 105 est un semi-conducteur destiné à être dopé P (figure 6A).

Puis, on forme au moins une tranchée 108 dans la couche à base du premier matériau 106 et dans la couche à base du deuxième matériau 105, la tranchée 108 dévoilant la couche isolante 102 du substrat. La tranchée 108 peut avoir une dimension critique dc comprise par exemple entre 1 et 20 nanomètres, ou entre 1 et 10 nanomètres, ou inférieure à 5 nanomètres, par exemple de l'ordre de 2 nanomètres. La tranchée 108 peut être réalisée par des étapes de photolithographie, puis de gravure, par exemple de gravure anisotrope à l'aide de chlore ou de brome. Des blocs 110 et 112 distincts, séparés par la tranchée 108, sont ainsi réalisés. Ces blocs 110 et 112 sont destinés à former respectivement une anode et une cathode d'une triode ou d'un transistor (figure 6B).

Ensuite, la tranchée 108 est remplie à l'aide d'un premier matériau diélectrique 114, par exemple à base d'un diélectrique tel que du SiO₂ ou d'un diélectrique « high-k » tel que du HfO₂, du ZrO₂ ou du Y₂O₃, ou du LaO₂. Une zone isolante 115 de canal est ainsi formée entre les blocs 110 et 112.

Selon une possibilité (non représentée), le remplissage de la tranchée 108 peut être réalisé de sorte que le premier matériau diélectrique 114 déborde de l'embouchure de la tranchée 108 et forme une couche recouvrant les blocs 110 et 112. Selon cette possibilité, ladite couche à base du premier matériau diélectrique 114 recouvrant les blocs 110 et 112 et la tranchée 108 remplie, peut former une couche de diélectrique de grille, destinée à être gravée pour former une zone de diélectrique de grille.

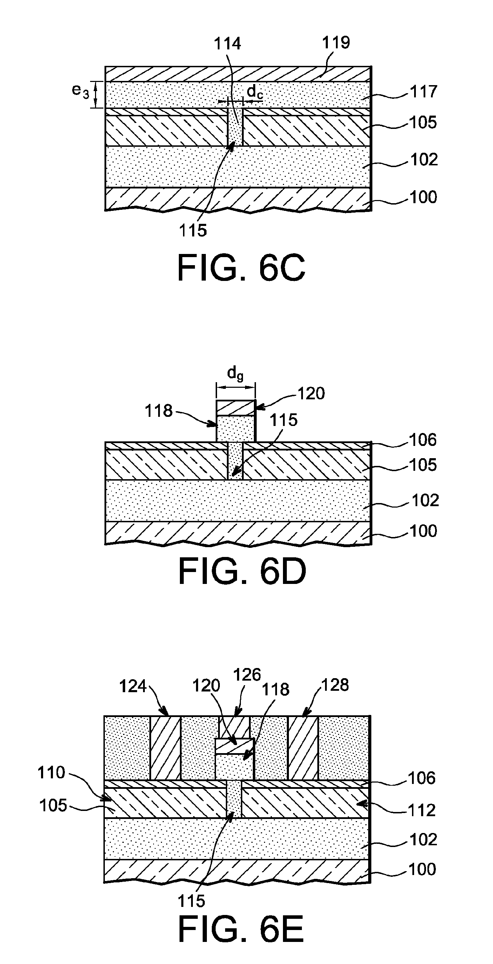

Selon une variante (figure 6C), le remplissage de la tranchée 108 par le premier matériau diélectrique 114 peut être réalisé jusqu'au niveau de l'embouchure de la tranchée 108. Ensuite, une couche de diélectrique 117 de grille, d'épaisseur e₃, par exemple comprise entre 1 et 20 nanomètres, ou entre 1 et 10 nanomètres, ou entre 1 nanomètre et 5 nanomètres, et à base d'un deuxième matériau diélectrique 117 différent du premier matériau diélectrique 114, peut être formée sur la tranchée 108 remplie, ainsi que sur les blocs 110 et 112. L'épaisseur e₃ de la couche 116 de diélectrique de grille, est prévue, de préférence, pour être supérieure à la dimension critique dc de la zone isolante 115 à base du premier matériau diélectrique 114.

Puis, on forme une couche à base d'un matériau 119 de grille, sur la couche de diélectrique 117 de grille. Le matériau 119 de grille peut être par exemple à base d'un matériau semi-conducteur tel que PolySi ou du PolySiGe, ou/et d'un métal tel que du W ou du Mo.

Ensuite, dans les couches 117 et 119, de diélectrique de grille et de matériau de grille, on forme un motif d'au moins une grille 120 reposant sur une zone 118 de diélectrique de grille, par exemple à l'aide d'étapes de photolithographie puis de gravure. Le motif de grille 120 est situé dans un plan différent de celui des blocs 110, 112 et de la zone isolante 115 séparant ces blocs. Le motif de grille 120 peut avoir une dimension critique dg comprise entre 2 et 20 nanomètres (figure 6D).

Puis, un dopage de type N ou de type P, de régions des blocs 110 et 112, à base du premier matériau 104, peut être réalisé.

Ensuite, des contacts 124, 126, 128, peuvent être formés respectivement, sur le bloc 110 d'anode, sur la grille 120, et sur le bloc 112 de cathode. Les contacts 124, 126, 128, peuvent être réalisés par exemple par dépôt d'une couche isolante 121, par exemple à base de SiO₂, recouvrant la grille 120 et les blocs 110, 112, puis formation d'ouvertures dans la couche isolante 121, dont au moins une ouverture dévoilant le premier bloc 110, au moins une ouverture dévoilant le deuxième bloc 112, et au moins une ouverture dévoilant la grille 120. Ensuite, un remplissage desdites ouvertures, par exemple à l'aide d'au moins un matériau métallique, est effectué (figure 6E). Selon une possibilité de mise en oeuvre du procédé, après réalisation de la grille 120 et avant formation des contacts 124, 126, 128, des espaceurs isolants peuvent être formés de part et d'autre de la grille.

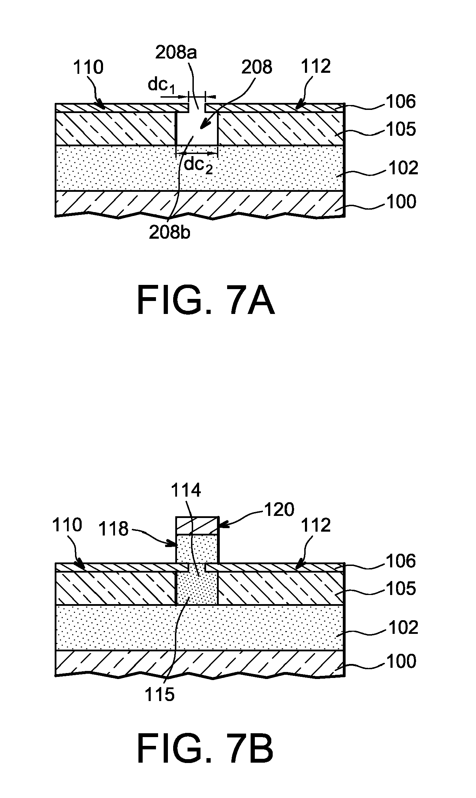

Une variante de mise en oeuvre de la zone isolante 115 de canal séparant les blocs 110 et 112, est illustrée sur les figures 7A et 7B.

Pour cette variante, on forme au moins un premier trou 208a dans la couche à base du premier matériau 106, et au moins un deuxième trou 208b dans la couche à base du deuxième matériau 105 et dans le prolongement du premier trou 208a. Lesdits trous 208a, 208b peuvent être réalisés par exemple par photolithographie, puis gravure anisotrope à l'aide par exemple de chlore ou de brome. Ensuite, on élargi le deuxième trou 208b par exemple par gravure isotrope du premier matériau 106, par exemple à l'aide de fluor (figure 7B). Après gravure isotrope, le premier trou 208a et le deuxième trou 208b ont des dimensions critiques respectives dc₁ et dc₂ telles que dc₂ > dc₁, et forment une tranchée 208 à embouchure rétrécie, séparant les blocs 110 et 112. Ensuite, on peut effectuer des étapes telles que décrites précédemment en liaison avec les figures 6A-6D, de formation d'une zone isolante 115 de canal par remplissage de la tranchée 208, puis de formation d'une zone 118 de diélectrique de grille et d'une grille 120. La figure 7B illustre le dispositif de transistor une fois la grille 120 formée. Sur cette figure, le premier bloc d'anode 110 et le deuxième bloc 112 de cathode comprennent, respectivement : une zone à base d'un matériau métallique 106 reposant sur une zone à base d'un matériau semi-conducteur 105, et une autre zone à base du matériau métallique 106 reposant sur une autre zone à base du matériau semi-conducteur 105. Les zones métalliques de la cathode et de l'anode sont situées à une première distance minimale dc₁ l'une de l'autre, tandis que les zones semi-conductrices de la cathode et de l'anode sont situées à deuxième distance minimale dc₂ l'une de l'autre, supérieure à la première distance dc₁.

## Revendications

1. Dispositif microélectronique doté d'au moins un transistor ou triode à effet tunnel, reposant sur un substrat (101-100) et comprenant :
- au moins un premier bloc (110) destiné à jouer le rôle d'anode et au moins un deuxième bloc (112) destiné à jouer le rôle de cathode, le premier bloc (110) et le deuxième bloc (112) étant séparés par une zone isolante (115) de canal, le premier bloc (110) le deuxième bloc (112) et la zone isolante (115) de canal reposant sur ledit substrat, le premier bloc (110) et/ou le deuxième bloc (112) comprenant au moins un empilement de deux couches de matériaux (105,106) différents,
- au moins une zone (118) de diélectrique de grille reposant sur ladite zone isolante (115) de canal, et au moins une grille (120) reposant sur ladite zone (118) de diélectrique de grille.

2. Dispositif microélectronique selon la revendication 1, la zone isolante (115) de canal ayant une dimension critique (dc,dc₂) comprise entre 1 et 10 nanomètres.

3. Dispositif microélectronique selon la revendication 1 ou 2, le premier bloc (110) et le deuxième bloc (112) comprenant respectivement : au moins une première zone métallique, et au moins une deuxième zone métallique, la première zone métallique et la deuxième zone métallique étant séparées d'une première distance (dc,dc₁) par la zone isolante (115) de canal.

4. Dispositif microélectronique selon la revendication 1, le premier bloc (110) et le deuxième bloc (112) comprenant respectivement : au moins une troisième zone, semi-conductrice, sur laquelle repose la première zone métallique, et au moins une quatrième zone, semi-conductrice, sur laquelle repose la deuxième zone métallique, la troisième zone et la quatrième zone étant séparées d'une deuxième distance (dc₂) par la zone isolante (115) de canal.

5. Dispositif microélectronique selon la revendication 4, la première distance (dc₁) séparant lesdites première et deuxième zones, métalliques, étant inférieure à ladite deuxième distance (dc₂) séparant lesdites troisième et quatrième zones, semi-conductrices.

6. Dispositif microélectronique selon l'une des revendications 4 ou 5, dans lequel ladite première zone et ladite deuxième zone ont une première épaisseur (e₁), ladite troisième zone et ladite quatrième zone ayant une deuxième épaisseur (e₂) supérieure à ladite première épaisseur (e₁).

7. Dispositif microélectronique selon l'une des revendications 1 à 6, dans lequel la zone (118) de diélectrique de grille a une épaisseur donnée (e₃), ladite zone isolante (115) de canal ayant une dimension critique (dc,dc₁) inférieure à ladite épaisseur donnée (e₃).

8. Dispositif microélectronique selon l'une des revendications 1 à 7, ladite zone isolante (115) de canal et ladite zone (118) de diélectrique de grille, étant à base de matériaux diélectriques (114,118) différents.

9. Dispositif microélectronique selon l'une des revendications 1 à 8, ladite zone isolante (115) de canal étant à base d'un matériau diélectrique (114) de constante diélectrique élevée (high-k) ou de constante diélectrique k₁ > 4,3.

10. Procédé de réalisation d'un dispositif microélectronique doté d'au moins un transistor ou triode, à effet tunnel, comportant les étapes consistant à :
a) fournir un substrat recouvert d'une ou plusieurs couches minces,
b) réaliser dans lesdites couches minces au moins une tranchée (108, 208) séparant au moins un premier bloc (110) destiné à jouer le rôle d'anode et au moins un deuxième bloc (112) destiné à jouer le rôle de cathode,
c) remplir la tranchée (108, 208) à base d'au moins un matériau diélectrique (114) de manière à former au moins une zone isolante (115) de canal entre le premier bloc (110) et le deuxième bloc (112),
d) former au moins une zone (118) de diélectrique (117) de grille reposant sur ladite zone isolante (115) de canal et au moins une grille (120) sur ladite zone (118) de diélectrique de grille.

11. Procédé selon la revendication 10, la zone isolante (115) de canal ayant une dimension critique (dc,dc₁) comprise entre 1 et 10 nanomètres.

12. Procédé selon l'une des revendications 10 ou 11, dans lequel ladite zone (118) de diélectrique de grille a une épaisseur (e₃) donnée, ladite zone isolante (115) de canal ayant une dimension critique (dc,dc₁) inférieure à ladite épaisseur (e₃) donnée.

13. Procédé selon l'une des revendications 10 à 12, dans lequel à l'étape d), la formation de la zone (118) de diélectrique de grille comprend : le dépôt d'au moins une couche de diélectrique (117) de grille sur le premier bloc (110), la zone isolante (115) de canal et le deuxième bloc (112), ladite couche de diélectrique de grille et ladite zone isolante (115) de canal étant à base de matériaux diélectriques (114,118) différents.

14. Procédé selon l'une des revendications 10 à 12, dans lequel à l'étape c), le remplissage est réalisé de manière à déborder de l'embouchure de la tranchée (108, 208) et à former une couche à base dudit matériau diélectrique (114) reposant sur le premier bloc (110), ainsi que sur le deuxième bloc (112) et la tranchée (108, 208) remplie, la formation de la zone (118) de diélectrique de grille à l'étape d), comprenant : une gravure de ladite couche à base dudit matériau diélectrique (114).

15. Procédé selon l'une des revendications 10 à 14, lesdites couches minces comprenant au moins une première couche, à base d'au moins un matériau (106) métallique.

16. Procédé selon l'une des revendications 10 à 15, lesdites couches minces comprenant un empilement formé d'au moins une première couche reposant sur au moins une deuxième couche, ladite première couche et ladite deuxième couche étant à base de matériaux (105,106) différents.

17. Procédé microélectronique selon l'une des revendications 15 ou 16, ladite deuxième couche étant à base d'au moins un matériau (105) semi-conducteur.

18. Procédé selon l'une des revendications 15 à 17, dans lequel à l'étape c) la formation de la tranchée (208) comprend :
- une gravure anisotrope de manière à former un premier trou dans ladite première couche et un deuxième trou dans ladite deuxième couche et dans le prolongement du premier trou,
- une gravure isotrope de ladite deuxième couche, sélective vis-à-vis de la première couche, de manière à élargir le deuxième trou.

19. Procédé selon l'une des revendications 15 à 17, dans lequel la première couche et la deuxième couche ont respectivement, une première épaisseur (e₁) et une deuxième épaisseur (e₂), la première épaisseur (e₁) étant inférieure à la deuxième épaisseur (e₂).
